# EUROPEAN PATENT APPLICATION

(11) **EP 1 932 587 A1**
(43) Date of publication of application: **18.06.2008**
(21) Application number: 06811552.6
(22) Date of filing: 04.10.2006
(51) Int. Cl.: B01J 19/08, F01N 3/02, F01N 3/08, H05H 1/24

(54) **ELECTRODE FOR PLASMA REACTOR**

(30) Priority: 05.10.2005 JP 2005292998
(71) Applicant: Daihatsu Motor Co., Ltd., Ikeda-shi, Osaka 563-8651 (JP); Res. Inst. of Innovative Techn. for The Earth, Soraku-gun, Kyoto 619-0292 (JP)
(72) Inventor: NAITO, Kazuya, Shiga 520-2593 (JP); KIM, Yooho, Shiga 520-2593 (JP); OGAWA, Takashi, Shiga 520-2593 (JP); IWASAKI, Ryouhei, Shiga 520-2593 (JP); TAN, Isao, Shiga 520-2593 (JP); WAKUDA, Mitsuhiro, Shiga 520-2593 (JP); TANAKA, Hirohisa, Shiga 520-2593 (JP); YAO, Shui-Liang, Soraku-Gun, Kyoto 619-0292 (JP)
(74) Representative: Kramer - Barske - Schmidtchen
(86) International application number: PCT/JP2006/320240
(87) International publication number: WO 2007/043543

(57) **Abstract**

This invention provides an electrode for plasma reactor, formed of a porous nickel or copper, with a view to improving processing characteristics in an electrode formed of a porous silicon carbide which has hitherto been used as an electrode in a plasma reactor.

## Description

### Technical Field

The present invention relates to an electrode for plasma reactor used in an apparatus for removing components that are included in exhaust gas discharged from a factory, a plant, an internal-combustion engine, and the like and have an adverse effect on environment.

### Background Art

Generally, there has been used a catalytic agent and a DPF (a diesel particulate filter) in order to decrease emission amount of CO (carbon monoxide), HC (hydrocarbon), NOx (nitrogen oxide), and PM (particulate material) that are included in exhaust gas discharged from, for example, a car engine, and particularly a diesel engine. However, in the case of the DPF, when PM in the DPF increases by collecting PM, ventilation of exhaust gas deteriorates, and exhaust resistance of the diesel engine increases. As a result, fuel efficiency and generating power decrease.

Considering this situation, recently it has been tried to remove the collected PM by applying oxidization and vaporization (CO₂) and reduce emission amount of the PM and the like by reforming exhaust gas. As for one of such trials, it has been known to use a plasma reactor, in an exhaust gas purification apparatus including a catalytic agent. For example, in Patent Document 1, there are provided two electrodes, one of those is a porous electrode, plasma is generated between the electrodes by applying an alternating current voltage to the electrodes, then exhaust gas is made to contact with the plasma, and soot particles in the exhaust gas is made to stay in the porous electrode by being passed through the porous electrode, and the soot particles are reacted with an activator such as ozone, NO₂, or radical by plasma.

In Patent Document 2, in a catalytic element formed of a piezoelectric element having a piezoelectric body and an electrode and formed by carrying a catalytic component, the electrode is porous, an alternating current voltage is applied from the electrodes, and a plasma-like state is generated in the vicinity of a surface of the piezoelectric body.

Patent Document 1: PCT Japanese Translation Patent Publication No. 2001-522302

Patent Document 2: Japanese Unexamined Patent Application Publication No. 2004-237135

However, in Patent Document 1, porous electrode is formed by SiC (silicon carbide). SiC is excellent in mechanical stability, but it may not be easy to perform a processing therefor. Hence, when the electrode is formed in accordance with the plasma reactor shape, for example, a cylindrical shape as shown in Fig. 2 in Patent Document 1, it is difficult to form the electrode in a method that a flat metal plate material is processed to become a cylinder shape.

In addition, in Patent Document 2, there is provided an electrode using stainless. Stainless is an alloy of iron and chrome, is excellent in processability as compared with SiC, and has a high thermal electron work function in iron. Thus, high inception voltage for plasma discharge is needed in order to generate plasma. Hence, in a car using a 12-volt battery as a power source, it is difficult to generate a high voltage, and thus there has been demanded a material capable of generating plasma in a low inception voltage for plasma discharge.

### Disclosure of the Invention

It is an object of the invention to solve the problem mentioned above.

Specifically, the electrode for plasma reactor according to the invention is formed of porous nickel or copper.

Porousness is defined as a configuration in which at least a plurality of penetrating holes are included, and thus also includes a configuration in which a plurality of non-penetrating holes are included. Penetrating means that inflow gas from one side opening of a hole passes the hole inside and flow out from the other side opening thereof. The penetrating hole, in which a gas inflow opening that is located on a surface different from a surface in which a gas outlet opening is located, is preferred. In addition, it is preferred that the penetrating hole, for example, has an inner section size enough to capture particulate shape such as PM included in exhaust gas that is discharged form a diesel engine. The penetrating hole and the non-penetrating hole as described above may be randomly and optionally formed, and may be orderly arranged at a predetermined interval away from each others.

With such a configuration, since nickel or copper has an excellent thermal electron work function as compared with metal materials such as tungsten, iron, and stainless, it is possible to generate plasma by applying a low inception voltage for plasma discharge. As a result, it is also possible to decrease power consumption. In addition, since the electrode is porous, for example, in a plasma reactor for disposing of exhaust gas including PM, it is possible to collect PM and progressively use the collected PM being excellent in thermal electron work function as a material of the electrode. Hence, it is possible to improve purification ability of the exhaust gas. Moreover, since the electrode is made of nickel or copper, it is possible to easily perform a processing, and it is possible to form a desired shape such as a wave plate shape, and a barrel shape, other than the flat plate shape.

If uniform plasma discharge is intended to be efficiently performed, it is preferred that at least one surface of the electrode has a dielectric material formed thereon. The dielectric material may be formed in a flat plate shape when porous nickel or copper is formed in a plate shape. In addition, the dielectric material is integrally formed with the porous nickel or copper by a coating process. As described above, when the dielectric material is provided on the porous nickel or copper by the coating process, it is possible to surely provide the dielectric material even when the electrode has a plate shape or a complex shape such as a cylindrical shape.

The invention has the configuration mentioned above, and thus it is possible to generate plasma by applying a low inception voltage for plasma discharge and to suppress power consumption to be maintained in low level. In addition, since the electrode is porous, for example, in a plasma reactor for disposing of exhaust gas including PM, it is possible to collect PM and progressively use the collected PM being excellent in thermal electron work function as a material of the electrode. Thus, it is possible to improve purification ability of the exhaust gas. Moreover, since the electrode is made of nickel or copper, it is possible to easily perform a processing, and it is possible to form a desired shape such as a wave plate shape, and a barrel shape, other than the flat plate shape.

### Brief Description of the Drawings

Fig. 1 is an enlarged sectional view illustrating a main portion of an embodiment of the invention.
Fig. 2 is a side view illustrating a combination when the electrodes of the embodiment are used in a plasma reactor.
Fig. 3 is a graph illustrating a PM removal ratio in a case where the electrode of the embodiment is used in the plasma reactor.
Fig. 4 is a picture illustrating a plasma radiation state in a case where a porous electrode of the invention is used.
Fig. 5 is a picture illustrating a plasma radiation state in a case where a conventional electrode is used.

### Best Mode for Carrying Out the Invention

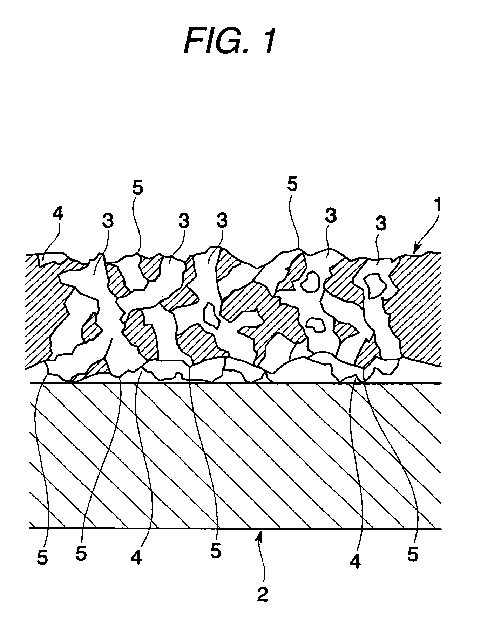

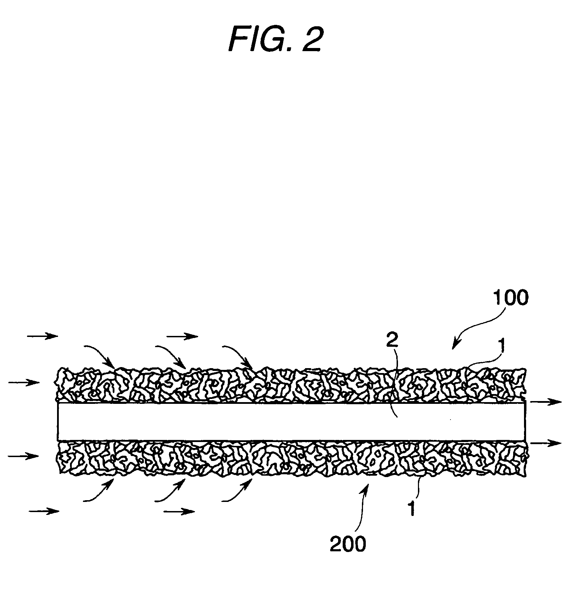

Hereinafter, an embodiment of the invention will be described with reference to Figs. 1 and 2.

An electrode 100 for plasma reactor according to the embodiment (hereinafter, it is referred to an electrode) includes a metal plate 1 having a plate shape and made of porous nickel and a dielectric material 2 that has a plate shape to be disposed on one surface of the metal plate 1, as shown in Fig. 1.

The electrode plate 1 has a shape that a flat part of each surface thereof scarcely exist, and includes a plurality of through-holes 3 that pass at least from one surface to the other surface, a plurality of concave portions 4 that do not pass but are depressed in each surface, and a plurality of convex portions 5. Each surface is formed in an unevenness shape in the entire range thereof and has a level difference formed thereon. The convex portions 5, when a voltage is applied to the electrode plate 1, become potential concentrating portions and contribute to improve plasma discharge efficiency. In addition, the concave portions 4 may be not always needed, and by forming the convex portions 5, the concave portions 4 may be formed as a lower part than the convex portions 5.

It may be not necessary for the through-holes 3 to directly pass from one surface to the other surface. In a case of being mounted on a plasma reactor, the through-holes can be employed when the through-holes are capable of passing gas to be processed such as exhaust gas, which includes PM discharged a diesel engine, from one surface to the other surface. In this case, the through-holes 3 may not be straight, and may bend, or branch into two or three. In addition, the inside wall of the through-holes 3 has also the same unevenness shape as the surface, and so it is possible to collect materials such as PM included in exhaust gas in the concave parts or between the inside walls. Accordingly, inside size or inner diameter of the through-holes 3 is set to be a size that makes PM hard to pass the through-holes 3 in order to be easily captured. For example, as for a diameter of a porous hole, it is possible to use #5 (1.9 mm), #8 (1.3 mm), #12 (0.9 mm), #58 (0.5 mm), or the like. The through-holes 3 is formed by using the size as described above, and thereby it is possible to act the electrode plate 1 itself as a filter with respect to PM, like DPF. However, since the holes are not alternately open and close like the DPF, pressure loss decreases.

With respect to the concave portions 4, there is no limitation in a size and a shape thereof, but it is preferred to have a size capable of comparatively deep capturing (collecting) a plurality of PM.

As for a method of forming the porous electrode plate, it is possible to employ the known methods such as the methods disclosed in Japanese Unexamined Patent Application Publication No. S53-65206, Japanese Unexamined Patent Application Publication No. S62-263974 or Japanese Unexamined Patent Application Publication No. H11-217602.

In a case where two electrode plates is used in a plasma reactor so as to face each other, the dielectric material 2 is set to have the same thickness and a distance enough to generate plasma when a predetermined voltage is applied to the electrode plate 3. The dielectric material 2 itself is not porous, and the gas to be processed in the plasma reactor can not pass through the inside thereof.

With such a configuration as described in Fig. 2, in order to be used in the plasma reactor, the electrode plates 1 are formed on both opposite sides of the dielectric material 2, in a state where the dielectric material 2 is interposed between the electrode 100 and the electrode 200 formed of only the electrode plate 1, that is, in a state where the dielectric material has a plate shape. In this case, for example, in a plasma reactor constituting an exhaust-gas purification device (or an exhaust-gas postprocessing device) that purifies exhaust gas of a diesel engine, the exhaust gas, for example, flows in the through-holes 3 of the electrode plate 1 from a surface of an outside of the electrodes 100 and 200, that is, a surface that does not sandwiches the dielectric material 2, passes through the electrode plate 1, and moves to the downstream side of the exhaust gas purification device through a gap between the electrode plate 1 and the dielectric material 2 (in Fig. 2, the arrow represents a moving direction of the exhaust gas).

When the exhaust gas passes through the electrode plates 1, most of PM included in the exhaust gas is captured in the through-holes 3 of each electrode plate 1. That is, each electrode plate 1 acts as a filter for the PM. Since a principal element of the PM is a carbon particle, the captured PM acts as a part of the electrode plate 1. Hence, when a voltage is applied to the electrode plate 1, electrons are discharged from the electrode plate 1 itself, and electrons are also discharged from the captured PM, thereby starting plasma discharge. Accordingly, it is possible to efficiently generate plasma.

Moreover, plasma is generated between the electrode plates 1, and thus the captured PM is sequentially combusted and removed. Therefore, the through-holes 3 of the electrode plates 1 do not choke, and a function as a filter of the electrode plate 1 does not deteriorate even when the exhaust gas is continuously supplied to the plasma reactor. Accordingly, since a decrease in reactor aperture ratio can be prevented, it is possible to prevent a decrease in fuel efficiency and power of a diesel engine.

As described above, the electrode plate 1 is made of nickel that is excellent in a work function and has a porous structure. In the electrode plate, the surface having abundant unevenness, the inside shape of the through-holes 3 that act as a filter for the PM and the captured PM act as a part of the electrode plate 1, and thus it is possible to efficiently start plasma discharge. Hence, the inception voltage for plasma discharge applying to the electrode plate 1 can be decreased, and it is possible to decrease power consumption. In addition, since the substantially entire surfaces of the electrode plates 1 are formed in an unevenness shape, plasma can be uniformly generated between the electrode plates 1, and thus it is possible to improve purification ability for the exhaust gas.

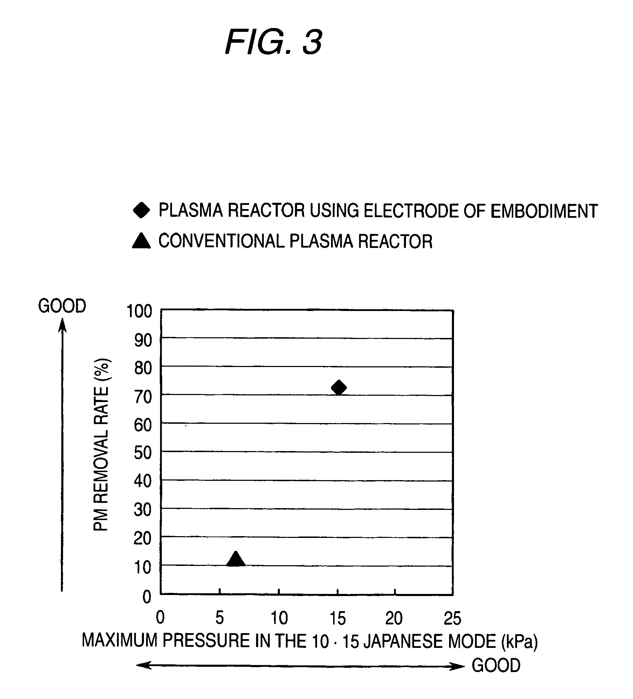

As shown in Fig. 3, it was possible to know that purification ability for exhaust gas, particularly a removal ratio of PM remarkably improves as compared with the conventional plasma reactor. The conventional plasma reactor used in the comparison is configured so that electrodes combining an aluminium plate and a stainless electrode plate of which both surfaces have grooves formed thereon are employed and exhaust gas passes through the grooves. Evaluation of the PM removal ratio is performed under 10.15 mode condition in which a dynamometer is used. Here, the 10.15 Japanese mode cycle is defined as a mode (warm start) for evaluating emission and fuel efficiency of a passenger car in Japan. In addition, the evaluation is performed under the condition in which an output of a primary boost power source is 600 W, by using a pulse power source, which is boosted as much as two stages, as a power source for generating plasma. As described above, in the plasma reactor using combination of the electrode 100 and the electrode 200 according to the embodiment, PM removal rate could be about 7 times and pressure loss (Maximum pressure in the 10 · 15 Japanese mode) could be lower about 3 times as excellent as the conventional plasma reactor.
Here, the reactor aperture ratio is an area capable of passing exhaust gas in a sectional area of a plasma reactor, and PM removal ratio is obtained by dividing a PM discharge amount in the rear side of a plasma reactor by a PM discharge amount in a straight pipe where a plasma reactor is not provided. Accordingly, in a plasma reactor that is mounted on an exhaust gas purification device combined with a diesel engine, the reactor aperture ratio can be increased, and thus it is possible to suppress exhaust resistance of a diesel engine and prevent a decrease in fuel efficiency and generating power.

Table 1 represents a research about a primary power generating condition at the time of starting discharge and a condition at the time of radiating plasma when a primary output voltage is 300 V, by using the conventional electrode of which both surfaces have grooves formed thereon and the porous electrode according to the invention and a pulse power source that is boosted as much as two stages. A voltage at the time of radiating plasma and generation of a whisker-shaped waveform that is a characteristic waveform at the time of generating plasma are judged by an oscilloscope, and are measured by using a system capable of judging the inception voltage for plasma discharge. When the electrode according to the invention is used, it is possible to realize that the inception voltage for plasma discharge and the power consumption at the time of starting discharge are low as compared with the case of using the conventional electrode.

**Table 1**

| | | CHARACTERISTIC FOR THE PLASMA AT INCEPTION VOLTAGE (PRIMARY VOLTAGE) | CHARACTERISTIC FOR THE PLASMA AT 300 V (PRIMARY VOLTAGE) |
|---|---|---|---|
| POROUS ELECTRODE (EXAMPLE) | VOLTAGE (V) | 104 | 300 |
| | CURRENT (A) | 0.01 | 0.1 |
| | POWER CONSUMPTION (W) | 65 | 122 |
| | POWER FACTOR (COSΦ) | 0.52 | 0.56 |
| CONVENTIONAL ELECTRODE (COMPARATIVE EXAMPLE) | VOLTAGE (V) | 161 | 300 |
| | CURRENT (A) | 0.02 | 0.09 |
| | POWER CONSUMPTION (W) | 79 | 118 |
| | POWER FACTOR (COSΦ) | 0.55 | 0.56 |

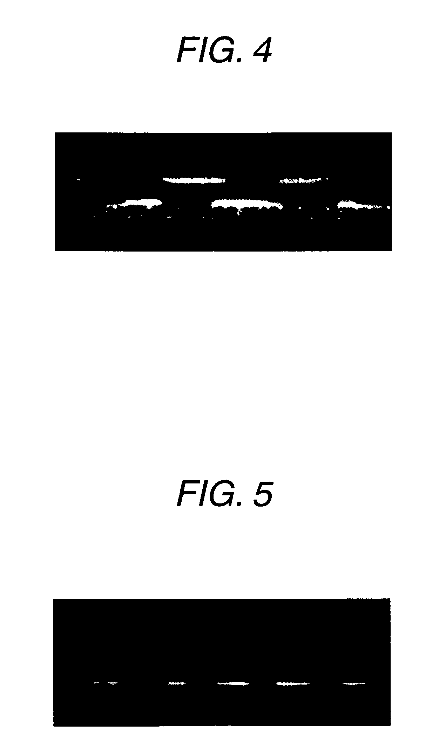

In addition, Fig. 4 is a picture illustrating a plasma radiation state in a case where a porous electrode of the invention is used. Fig. 5 is a picture illustrating a plasma radiation state in a case where a conventional electrode is used. Referring to Fig. 4 and Fig. 5, it is possible to know that plasma radiation luminance is high when the porous electrode according to the invention is used.

In the embodiment, the dielectric material 2 having a flat plate shape was described, but the dielectric material may be formed by coating the electrode plate made of porous nickel. The electrode plate itself coated with the dielectric material may have various shape and structure such as the plate shape mentioned above, a wave plate shape, a cylindrical shape, a winding structure and a shape other than described above. The dielectric material may be coated on both sides of surfaces opposite to each other in the surfaces of the electrode plate, that is, the electrode plate having a plate shape, inside and outside surfaces in the winding structure, a sectional surface corresponding to an end grain, at least one surface of the electrode plate, or an inside surface of the through-holes. When the dielectric material is coated, the through-holes of the electrode plate make gas pass therethrough, and capture PM. Accordingly, in order not to choke the openings of the through-holes, an inside size enough for the through-holes to capture the PM is secured, and the dielectric material is coated.

As described above, in the electrode where a dielectric material is coated on the electrode plate, a pair of electrodes is disposed at a distance capable of starting plasma discharge when the electrodes are mounted on the plasma reactor. In addition, the plasma reactor is configured so that exhaust gas and the like pass through space between the electrodes that generate plasma.

With respect to the detailed configuration about each part, the invention is not limited to the embodiment mentioned above, and may be modified in various forms without departing from the technical spirit of the invention.

### Industrial Applicability

Exemplary applications of the invention include a plasma reactor of a device installed to process exhaust gas including PM such as an exhaust gas purification device for car, and an exhaust gas processing device in a facilities discharging smoke like a plant and the like.

## Claims

1. An electrode for plasma reactor, wherein the electrode is formed of porous nickel or copper.

2. The electrode for plasma reactor according to Claim 1, wherein at least one surface of the electrode has a dielectric material formed thereon.

3. The electrode for plasma reactor according to Claim 1, wherein the electrode has an electrode plate formed of porous nickel or copper.

4. The electrode for plasma reactor according to Claim 3, wherein the electrode plates are disposed to face each other with a dielectric material interposed therebetween.

5. The electrode for plasma reactor according to Claim 3, wherein the electrode plate has a plurality of through-holes formed to pass at least from one surface of the electrode plate to the other surface thereof.

6. The electrode for plasma reactor according to Claim 3, wherein a surface of the electrode plate has a plurality of convex portions and concave portions formed to be depressed and not to be penetrated.

7. The electrode for plasma reactor according to Claim 5, wherein the through-holes directly pass from the one surface to the other surface, along a flow direction of gas to be processed.

8. The electrode for plasma reactor according to Claim 5, wherein the through-holes branch.

9. The electrode for plasma reactor according to Claim 5, wherein each of the through-holes has an unevenness shape formed on an inside wall thereof.

10. The electrode for plasma reactor according to Claim 2, wherein the dielectric material is formed by being coated on the electrode plate.
